(19) Europäisches Patentamt / European Patent Office / Office européen des brevets

(11) **EP 1 882 984 B1**

(12) **EUROPEAN PATENT SPECIFICATION**

(45) Date of publication and mention
of the grant of the patent:
**12.10.2011 Bulletin 2011/41**

(51) Int Cl.:
*G03F 7/20* (2006.01)     *G02B 17/00* (2006.01)

(21) Application number: **06425539.1**

(22) Date of filing: **28.07.2006**

(54) **Multi-reflection optical systems and their fabrication**

Optische Multireflexionssysteme und ihre Herstellung

Systèmes multi-réflectifs optiques et leur fabrication

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**30.01.2008 Bulletin 2008/05**

(73) Proprietor: **Media Lario s.r.l.**
**23842 Bosisio Parini (LC) (IT)**

(72) Inventors:
• **Zocchi, Fabio**
**23842 Bosiso Parini (LC) (IT)**
• **Benedetti, Enrico**
**23842 Bosiso Parini (LC) (IT)**

(74) Representative: **Molony, Anna et al**
**Chapman Molony**
**Thorpe House**
**17 Dormer Place**
**Leamington Spa CV32 5AA (GB)**

(56) References cited:
**US-A1- 2004 108 473     US-A1- 2006 097 202**

• **ZOCCHI FABIO E ET AL: "Design and optimization of collectors for extreme ultra-violet lithography" PROC SPIE INT SOC OPT ENG; PROCEEDINGS OF SPIE - THE INTERNATIONAL SOCIETY FOR OPTICAL ENGINEERING; EMERGING LITHOGRAPHIC TECHNOLOGIES X 2006, [Online] vol. 6151, pages 61510T-1-61510T-11, XP002418359 Retrieved from the Internet: URL:http://spiedl.aip.org/getabs/servlet/G etabsServlet? prog=normal&id=PSISDG00615100 000161510T000001&idtype=cvips&gifs=yes> [retrieved on 2006-03-23]**
• **F. E. ZOCCHI: "High-efficiency collector design for extreme-ultraviolet and x-ray applications" APPLIED OPTICS, [Online] vol. 45, no. 35, pages 8882-8888, XP002418360 Retrieved from the Internet: URL:http://www.opticsinfobase.org/ DirectPD FAccess/9175DB49-BDB9-137E-C8DF60BE74F4A97 D_119024.pdf? da=1&id=119024&seq=0&CFID=404 26834&CFTOKEN=29860690> [retrieved on 2006-08-07]**

EP 1 882 984 B1

**Description**

The present invention relates to reflective (mirror based) optics, and more particularly to multi-reflection optical systems and their fabrication.

The present invention finds application in diverse optical systems, examples being collector optics for lithography, and telescope or imaging (e.g. X-ray) systems.

A well known optical design for X-ray applications is the type I Wolter telescope. The optical configuration of type I Wolter telescopes consists of nested double-reflection mirrors operating at grazing incidence angles low enough to assure high reflectivity from the coating material, normally gold. In type I Wolter mirrors, the X-ray radiation from distant sources is first reflected by a parabolic surface and then by a hyperboloid, both with cylindrical symmetry around the optical axis.

More recently, a variation of the type I Wolter design already proposed for other applications, in which the parabolic surface is replaced by an ellipsoid, has found application for collecting the radiation at 13.5 nm emitted from a small hot plasma used as a source in Extreme Ultra-Violet (EUV) microlithography, currently considered a promising technology in the semiconductor industry for the next generation lithographic tools. Here, there is a performance requirement to provide a near constant radiation energy density or flux across an illuminated silicon wafer target at which an image is formed. The hot plasma in EUV lithography source is generated by an electric discharge (Discharge Produced Plasma or DPP source) or by a laser beam (Laser Produced Plasma or LPP source) on a target consisting of Lithium, Xenon, or Tin, the latter apparently being the most promising. The emission from the source is roughly isotropic and, in current DPP sources, is limited by the discharge electrodes to an angle of about 60° or more from the optical axis. EUV lithography systems are disclosed, for example, in US2004/0265712A1, US2005/0016679A1 and US2005/0155624A1.

Zocchi, Fabio et al., "Design and optimisation of collectors for extreme ultraviolet lithography", Proc. SPIE Vol. 6151, pp. 615110T-1 to 615110T-11, discloses a reflective optical system comprising one or mirrors, in which radiation from the source undergoes successive grazing incidence reflections at reflective surfaces.

US 2006/0097202 discloses nested mirror collector systems for EUV and x-ray applications. US 2004/01084731 discloses EUV/x-ray lithography systems, focusing on high energy plasma sources.

The purpose of the collector in EUV sources is to transfer the largest possible amount of in-band power emitted from the plasma to the next optical stage, the illuminator, of the lithographic tool. The collector efficiency is defined as the ratio between the in-band power at the intermediate focus and the total in-band power radiated by the source in 2n sr. For a given maximum collection angle on the source side, the collector efficiency is mainly determined by the reflectivity of the coating on the optical surface of the mirrors.

A problem with known systems is that that collector efficiency is significantly lower than it might be since the reflectivity of the coating is not exploited in the most efficient way; any improvement in the collector efficiency is highly desirable.

A further problem is that, with the collector efficiencies available, there is imposed the need to develop extremely powerful sources, and to have high optical quality and stability in the collector.

A further problem is that, with the collector efficiencies available, the overall efficiency of the lithographic equipment may not be high enough to sustain high volume manufacturing and high wafer throughput.

A further problem is that the collector lifetime may be relatively short due to exposure to extremely powerful sources.

The present invention seeks to address the aforementioned and other issues.

According to one aspect of the present invention there is provided a collector reflective optical system, in which radiation from a radiation source is directed to an image focus, comprising: one or more mirrors, the or each mirror being symmetric about an optical axis extending through the radiation source and the or each mirror having at least first and second reflective surfaces whereby, in use, radiation from the source undergoes successive grazing incidence reflections in an optical path at said first and second reflective surfaces; characterized in that said at least first and second reflective surfaces are formed such that the angles of incidence of said successive grazing incidence reflections at said first and second reflective surfaces are substantially equal for all rays incident on said reflective surfaces.

Preferably, the or each mirror is formed as an electroformed monolithic component, and wherein the first and second reflective surfaces are each provided on a respective one of two contiguous sections of the mirror.

Preferably, for the or each mirror: said at least first and second reflective surfaces have figures, and positions and/or orientations relative to the optical axis whereby said angles of incidence are equal.

More preferably, for the or each mirror: the first reflective surface is nearest to the radiation source, and radiation from the second reflective surface is directed to the image focus on the optical axis; and wherein said first and second reflective surfaces are defined, for a given point of reflection at said reflective surfaces, by

$$
\begin{cases}
\rho_2 \rho_1 = k \sin^{-4}\left(\dfrac{\theta_2 - \theta_1}{4}\right) \\[2mm]
\rho_1 - \rho_2 = 2c \dfrac{\cos\theta_2 - \cos\theta_1}{\cos(\theta_1 - \theta_2) - 1} \\[2mm]
\rho_1 \cos\theta_1 + \rho_2 \cos\theta_2 + (2a - \rho_1 - \rho_2)\cos\left(\dfrac{\theta_1 + \theta_2}{2}\right) = 2c
\end{cases}
$$

where $\rho_1$ is the length from the source to the first reflective surface,

$\rho_2$ is the length from the image focus to the second reflective surface,

$\theta_1$ is the angle between the optical axis and a line joining the source and a first point of reflection at the first reflective surface,

is the angle between the optical axis and a line joining the image focus and a second point of reflection at the second reflective surface,

2c is the length along the optical axis from the source to the image focus,

2a is the constant length of the optical path, and

*k* is a constant.

The values of *a* and *k* are more preferably determined by

$$
a = \frac{\rho_{1,R} + \rho_{2,R}}{2} \ ,
$$

and

$$
k = \rho_{1,R} \rho_{2,R} \sin^{4}\left(\frac{\theta_{2,R} - \theta_{1,R}}{4}\right)
$$

where subscript "R" denotes values for the point of intersection R of the first and second reflective surfaces.

According to another aspect of the invention there is provided a collector optical system for EUV lithography, comprising the reflective optical system of any of claims 1 to 5 of the appended claims, wherein radiation is collected from the radiation source.

According to another aspect of the invention there is provided an EUV lithography system comprising: a radiation source, for example a LPP source, the collector optical system of claim 6 of the appended claims; an optical condenser; and a reflective mask.

According to another aspect of the invention there is provided an imaging optical system for EUV or X-ray imaging, comprising the reflective optical system of any of claims 1 to 5 of the appended claims.

According to another aspect of the invention there is provided an EUV or X-ray imaging system, comprising: the imaging optical system of claim 8 of the appended claims; and an imaging device, for example a CCD array, disposed at the image focus.

According to another aspect of the invention there is provided an EUV or X-ray telescope system, comprising: the reflective optical system of any of claims 1 to 3 of the appended claims; wherein radiation from a source at infinity is reflected to the image focus.

In the EUV or X-ray telescope system, preferably, for the or each mirror: the first reflective surface is nearest to the radiation source, and radiation from the second reflective surface is directed to the image focus; and wherein said first and second reflective surfaces are defined, for a given point of reflection at said reflective surfaces, by

$$
\begin{cases}
\rho_1 + \rho_3 \cos(\theta_2 / 2) = 2c - \rho_2 \cos(\theta_2) \\
\rho_1 + \rho_3 = 2a - \rho_2
\end{cases}
$$

where $\rho_1$ is the length from a reference plane to the first reflective surface,

$\rho_2$ is the length from the image focus to the second reflective surface,

$\rho_3$ is the length between the points of incidence at said first and second reflective surfaces.

$\theta_2$ is the angle between the optical axis and a line joining the image focus and a second point of reflection at the second reflective surface,

2c is the length along the optical axis from the source to the image focus,

2a is the constant length of the optical path, and

*k* is a constant.

The values of *a* and *k* are more preferably determined by

$$a = \frac{\rho_{1,R} + \rho_{2,R}}{2},$$

and

$$k = \rho_{2,R} \sin^4\left(\frac{\theta_{2,R}}{4}\right),$$

where subscript "R" denotes values for the point of intersection R of the first and second reflective surfaces.

According to another aspect of the invention there is provided an EUV or X-ray imaging system, comprising: the EUV or X-ray telescope system of any of claims 10 to 12 of the appended claims; and an imaging device, for example a CCD array, disposed at the image focus.

In each of the aforementioned aspects of the invention, a plurality of mirrors may be provided in nested configuration.

Also, the two of more of the mirrors may each have a different geometry.

In addition, the mirrors may have mounted thereon, for example on the rear side thereof, one or more devices for the thermal management of the mirror, for example cooling lines, Peltier cells and temperature sensors.

The mirrors may have mounted thereon, for example on the rear side thereof, one or more devices for the mitigation of debris from the source, for example erosion detectors, solenoids and RF sources.

In accordance with embodiments of the invention is two-reflection mirror for nested grazing incidence optics, in which significantly improved overall reflectivity is achieved by making the two grazing incidence angles equal for each ray. The invention is applicable to non-imaging collector optics for Extreme Ultra-Violet microlithography where the radiation emitted from a hot plasma source needs to be collected and focused on the illuminator optics. The invention is also described herein, embodied in a double-reflection mirror with equal reflection angles, for the case of an object at infinity, for use in X-ray applications.

An advantage of the invention is that the collection efficiency, is improved and/or maximised.

A further advantage of the invention lies in relaxing the effort in developing extremely powerful sources, improving the optical quality and stability of the collector output and increasing the collector lifetime.

A further advantage of the invention is the overall efficiency of the lithographic equipment is increased, allowing higher wafer throughput.

Embodiments of the invention will now be described in detail, by way of example, with reference to the accompanying drawings, in which:

Figure 1 (PRIOR ART) shows an example of a known EUV lithography system;

Figure 2 (PRIOR ART) shows the grazing incidence reflection in the collector optics of EUV lithography systems;

Figure 3 (PRIOR ART) depicts the conceptual optical layout of a known type I Wolter collector for EUV plasma sources;

Figure 4 illustrates theoretical reflectivity of selected materials at 13.5 nm.

Figure 5 shows geometry and conventions of the two-reflection mirror for EUV lithography applications, in accordance with one embodiment of the invention;

Figure 6 shows the optical layout of a nested collector according to a second embodiment of the invention

Figure 7 illustrates total reflectivity experienced by each ray as a function of the emission angle for the nested collector of Fig. 4 and for a type I Wolter design.

Figure 8 shows the geometry and conventions of the two-reflection mirror according to a third embodiment of the invention, when the source focus is at infinity, for example in X-ray imaging applications.

In the description and drawings, like numerals are used to designate like elements. Unless indicated otherwise, any individual design features and components may be used in combination with any other design features and components disclosed herein.

In the illustrations of optical elements or systems herein, unless indicated otherwise, cylindrical symmetry around the optical axis is assumed; and references to an "image focus" are references to an image focus or an intermediate focus.

In relation to the "substantially equal" grazing incidence angles in the fabricated mirrors, as used herein, this is to be interpreted as angles sufficiently similar as to result in enhanced collector efficiency, and more preferably significantly enhanced or maximised collector efficiency. While in no way limiting, it is to be interpreted as angles that differ by 10% or less, more preferably by 5% or less, and even more preferably by 1% or less. Ideally, the angles are identical, but this is not essential.

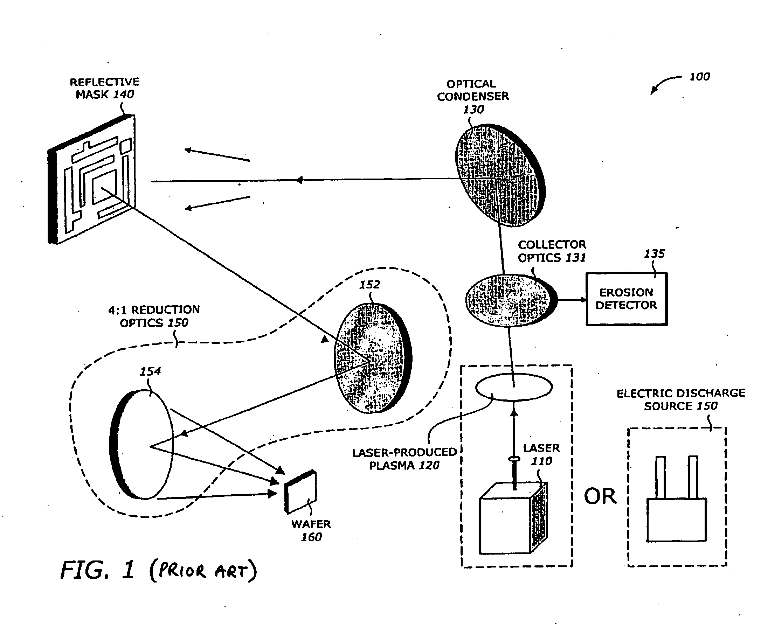

Figure 1 (PRIOR ART) shows an example of a known EUV lithography system. The system 100 includes a laser 110, a laser-produced plasma 120, an optical condenser 130, an optical collector 131, an erosion detector 135, a reflective mask 140, a reduction optics 150, and a wafer 160. Alternatively, the laser 100 and the laser produced plasma 120 can be replaced with an electric discharge source 150.

The laser 110 generates a laser beam to bombard a target material like liquid filament Xe or Sn. This produces the plasma 120 with a significant broadband extreme ultra-violet (EUV) radiation. The optical collector 131 collects the EUV radiation from the plasma. After the collector optics, the EUV light is delivered to the mask through a number of mirrors coated with EUV interference films or multilayer (ML) coating. The laser-produced plasma can be replaced with the electric discharge source 150 to generate the EUV light. The Xe or Sn is used in the electric discharge source 150. The optical condenser 130 illuminates the reflective mask 140 with EUV radiation at 13-14 nm wavelengths. The collector optics 131 and condenser optics 130 may include a ML coating. The optical collectors 131 may be eroded over time for being exposed to the plasma 120. The optical collectors 131 include circuitry or interface circuits to the erosion detector 135. The erosion detector 135 detects if there is an erosion in the single-layer or ML coating of the collectors 131. By monitoring the erosion in the ML coating continuously, severe erosion may be detected and replacement of eroded collectors may be performed in a timely fashion.

The reflective mask 140 has an absorber pattern across its surface. The pattern is imaged at 4:1 demagnification by the reduction optics 150. The reduction optics 150 includes a number of mirrors such as mirrors 152 and 154. These mirrors are aspherical with tight surface figures and roughness (e.g., less than 3 Angstroms). The wafer 160 is resist-coated and is imaged by the pattern on the reflective mask 140. Typically, a step-and-scan exposure is performed, i.e., the reflective mask 140 and the wafer 160 are synchronously scanned. Using this technique, a resolution less than 50 nm is possible.

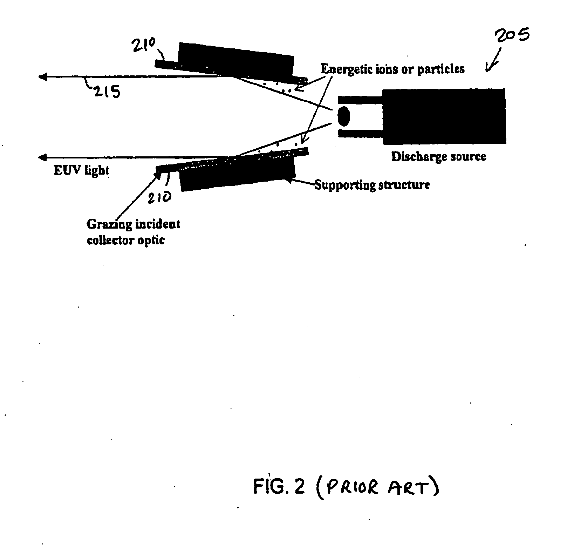

Figure 2 (PRIOR ART) shows the grazing incidence rejection in the collector optics of EUV lithography systems, i.e. in a sectional view within an exemplary EUV chamber. The light source, in this case a discharge produced plasma (DPP) source 205, and collector mirrors 210 for collecting and directing the EUV light 215 for use in the lithography chamber 105 are inside the EUV chamber. The collector mirrors 210 may have a nominally conical/cylindrical or elliptical structure.

Tungsten (W) or other refractory metals or alloys that are resistant to plasma erosion may be used for components in the EUV source. However, plasma-erosion may still occur, and the debris produced by the erosion may be deposited on the collector mirrors 210. Debris may be produced from other sources, e.g., the walls of the chamber. Debris particles may coat the collector mirrors, resulting in a loss of reflectivity. Fast atoms produced by the electric discharge (e.g., Xe, Li, Sn, or In) may sputter away part of the collector mirror surfaces, further reducing reflectivity.

In certain circumstances, a magnetic field is created around the collector mirrors to deflect charged particles and/or highly energetic ions 220 and thereby reduce erosion. A magnetic field may be generated using a solenoid structure. This magnetic field may be used to generate Lorentz force when there is a charged particle travelling perpendicular or at certain other angles with respect to the magnetic field direction. By applying high current (I) and many loops around the ferromagnetic tube, a high magnetic field can be generated.

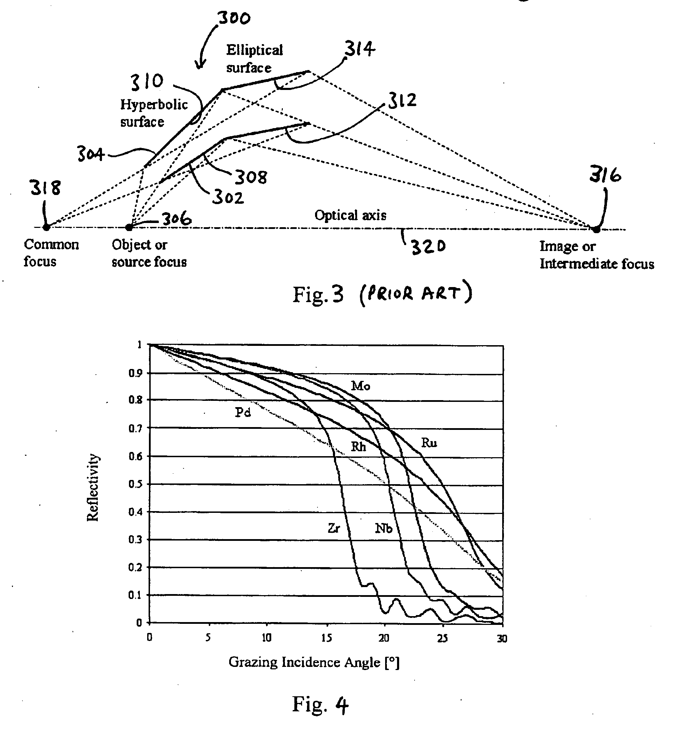

Figure 3 (PRIOR ART) depicts the conceptual optical layout of a known type I Wolter collector for EUV plasma sources. The purpose of the collector in EUV sources is to transfer the largest possible amount of in-band power emitted from the plasma to the next optical stage, the illuminator (130; Fig. 1), of the lithographic tool.

With reference to Fig. 3, although many more nested mirrors in the collector optical system 300 may be illustrated, only two (302, 304) are shown. The radiation from the source 306 is first reflected by the hyperbolic surfaces 308, 310, then reflected by the elliptical surfaces 312, 314, and finally focused to an image or intermediate focus 316 on the optical axis 320. As in the type I Wolter telescope mentioned above, the elliptical (312, 314) and the hyperbolic (308, 310) surfaces share a common focus 318. For each of the mirrors 302, 304, etc. the different sections on which the surfaces 308, 312 are disposed may be integral, or may be fixed or mounted together.

The output optical specification of the collector 300, in terms of numerical aperture and etendue, must match the input optical requirements for the illuminator (130; Fig. 1). The collector 300 is designed to have maximum possible efficiency, while matching the optical specification of the illuminator (130; Fig. 1) on one side and withstanding the thermal load and the debris from the plasma source 306 on the other side. Indeed, the power requirement for in-band radiation at the intermediate focus 316 has been seen to increase from the original 115 W towards 180 W and more, due to the expected increase in exposure dose required to achieve the desired resolution and line-width roughness of the pattern transferred onto the wafer (160; Fig. 1). Since the maximum conversion efficiency of both DPP and LPP sources is limited to a few percent, and since the reflectivity of normal incidence mirrors in the illuminator 130 and the projection optics box can not exceed about 70%, for each of the 6-8 mirrors or more along the optical path to the plane of the wafer 160, the collector 300 must withstanding thermal loads in the range of several kilowatts. Deformations induced by such high thermal loads on the thin metal shell which the mirrors 302, 304 are made of may jeopardise the stability and the quality of the output beam of the collector 300 even in presence of integrated cooling systems on the back surface of the mirrors.

It is apparent from the foregoing that any improvement in the collector efficiency has benefits for relaxing the need for developing extremely powerful sources, for increasing the wafer throughput of the lithographic equipment, and for improving the optical quality and stability of the collector output, as well as the benefit of increasing the collector lifetime.

Figure 4 illustrates theoretical reflectivity of selected materials at 13.5 nm, i.e. some example of the dependence of the reflectivity on the grazing incidence angle for some selected materials at a wavelength of 13.5 nm. For a given maximum collection angle on the source side, the collector efficiency is mainly determined by the reflectivity of the coating on the optical surfaces 308-314 of the mirrors 302, 304. Since each ray experiences two reflections, the overall reflectivity is given by the product of the reflectivity of each of the two reflections.

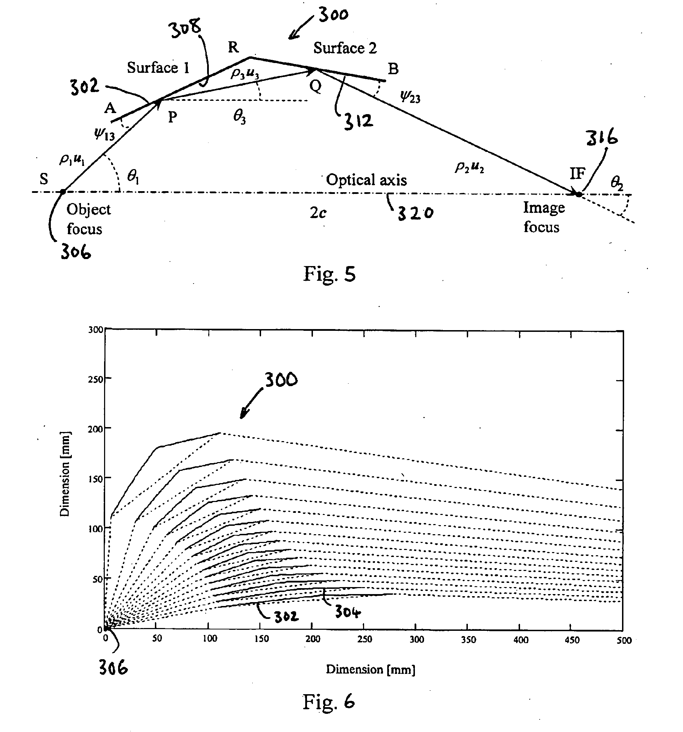

Figure 5 shows geometry and conventions of the two-reflection mirror 302 for EUV lithography applications, in accordance with one embodiment of the invention. Although many more nested mirrors in the collector optical system may be illustrated, only one (302) is shown. The design according to the invention is based on the discovery that the overall reflectivity is maximised when, for all rays, the two grazing incidence angles, and thus the reflectivity of the two reflections, are equal, at least for the kind of dependence on the grazing incidence angle shown in Fig. 4. This condition cannot be satisfied for all rays in a type I Wolter design. Indeed, in the latter, for each mirror, the two grazing incidence angles can be made equal for one ray at most.

In accordance with the invention, double-reflection collector mirrors 302, 304 are provided, in which the above condition (equal grazing incidence angle) is satisfied for all rays collected by each mirror 302, 304. A very brief theoretical treatment and the description of the design is given hereinafter, as is a comparison of the expected efficiency of a nested collector 300 according to an embodiment of the invention to the efficiency of type I Wolter collector. Although Abbe's condition is not satisfied in the collector according to an embodiment of the invention, coma aberration is of concern only to the extent it affects the collector efficiency. Due the finite size of the plasma source and possibly the shape errors of the collector mirrors, the relative contribution of coma aberration is considered negligible.

Mirror surface shapes.

The present invention employs, in the reflective surfaces of the mirrors, certain shapes/geometries in order to enhance performance; and in order that the mathematical definitions of these geometries may be better understood, the parameters and notation used in those representations will be briefly addressed below.

In the geometry shown in Fig. 5, a ray emitted from the object or source focus S (i.e. plasma source 306) is reflected at point P on the first surface 308, reflected at point Q on the second surface 312 and finally focused to the image or intermediate focus IF (316). Symmetry around the optical axis 320 is assumed. The positions of the source 306 and the image focus 316 define the vector $2c$ = IF-S of length $2c$. The ray path is described by the three adjacent vectors $\rho_1 \boldsymbol{u}_1$ =P-S; $\rho_2 \boldsymbol{u}_2$ =IF-Q, and $\rho_3 \boldsymbol{u}_3$ =Q-P of length $\rho_1$, $\rho_2$, and $\rho_3$, respectively. The direction of each vector is defined by the unit vectors $\boldsymbol{u}_1$, $\boldsymbol{u}_2$, and $\boldsymbol{u}_3$ forming angles $\theta_1$, $\theta_2$, and $\theta_3$ measured counterclockwise with respect to the optical axis 320. If three vectors $\rho_1 \boldsymbol{u}_1$, $\rho_2 \boldsymbol{u}_2$, and $\rho_3 \boldsymbol{u}_3$ are assigned as functions of a parameter $t$, the geometry of the cross sections of the two surfaces 308, 312 is defined with respect to S by the tips of the vectors $\rho_1 \boldsymbol{u}_1$ and $\rho_1 \boldsymbol{u}_1 + \rho_3 \boldsymbol{u}_3$.

In accordance with embodiments of the invention, the three vectors $\rho_1 \boldsymbol{u}_1$, $\rho_2 \boldsymbol{u}_2$, and $\rho_3 \boldsymbol{u}_3$ satisfy the following relation

$$\rho_1 \boldsymbol{u}_1 + \rho_2 \boldsymbol{u}_2 + \rho_3 \boldsymbol{u}_3 = 2c . \qquad (1)$$

In addition, in order for a spherical wave emitted from the source S (306) and reflected by the two surfaces 308, 312 to be focused to the image focus IF (316), the optical path is the same for all the rays. In accordance with embodiments of the invention, if 2a is the constant length of the optical path, then

$$\rho_1 + \rho_2 + \rho_3 = 2a . \qquad (2)$$

Finally, using the reflection conditions at point P and Q (the points of reflection at the surfaces 308 and 312, respectively) and the fact that, in accordance with embodiments of the invention, the two grazing incidence angles $\Psi_{13} = (\theta_1-\theta_3)/2$ and $\Psi_{23} = (\theta_3-\theta_2)/2$ are equal, i.e.

$$\theta_1 - \theta_3 = \theta_3 - \theta_2 \tag{3}$$

enables the geometry of the mirrors (reflective surfaces) in accordance with embodiments of the invention, to be defined. More specifically, the following system is employed in accordance with embodiments of the invention.

$$\begin{cases} \rho_2\rho_1 = k\sin^{-4}\left(\dfrac{\theta_2 - \theta_1}{4}\right) \\ \rho_1 - \rho_2 = 2c\dfrac{\cos\theta_2 - \cos\theta_1}{\cos(\theta_1 - \theta_2) - 1} \\ \rho_1\cos\theta_1 + \rho_2\cos\theta_2 + (2a - \rho_1 - \rho_2)\cos\left(\dfrac{\theta_1 + \theta_2}{2}\right) = 2c \end{cases} \tag{4}$$

If $\theta_1$, $a$, $c$, $k$ are given, these are 3 equations in 3 unknowns $\rho_1$, $\rho_2$, and $\theta_2$ that can be solved numerically. The resulting profile (mirror figure or geometry) is then rotated around the optical axis 320 to obtain the axial symmetric two-surfaces mirror 302. The surfaces 308, 312 defined by (4) cannot be described by second order algebraic equations. In particular, these surfaces 308, 312 are not generated by conic sections and do not have a common focus, as happens in two-reflection systems consisting of ellipsoids and/or hyperboloids.

The values $\theta_{1,R}$ and $|\theta_{2,R}|$ of the angles $\theta_1$ and $|\theta_2|$ at the intersection point R are the minimum angles at both the source 306 and the image focus 316. Since $\rho_3 = 0$ at R, assuming that c is assigned, the length $\rho_{1,R}$ and $\rho_{2,R}$ are known and the constants a and k are determined by relation (2) and (4a)

$$a = \frac{\rho_{1,R} + \rho_{2,R}}{2}, \tag{5}$$

$$k = \rho_{1,R}\rho_{2,R}\sin^4\left(\frac{\theta_{2,R} - \theta_{1,R}}{4}\right). \tag{6}$$

When $\theta_1$ is allowed increase from its minimum value $\theta_{1,R}$, relations (4) give the shape of both surfaces 308, 312 of the mirror 302. The maximum value of $\theta_1$ is arbitrary to a certain extent. A convenient choice is such that the minimum distance of the mirror 302 from the source 306 is some prescribed value $\bar{\rho}_1$ so that a spherical region of radius $\bar{\rho}_1$ around the source 306 is left free for the hardware required to mitigate the debris from the plasma source 306. Alternatively, in order to ease the mounting of the mirror on a common supporting structure, the maximum value for $\theta_1$ can be is chosen such that all the mirrors end at the same horizontal co-ordinate on side of the image focus 316.

The figures/geometries of the outer mirrors 304, etc. (see Fig. 6), are calculated iteratively as follows. The vertex R' of the second mirror 304 (Fig. 6) is defined by the intersection of the rays through points A and B. These rays also define the minimum values $\theta_{1,R'}$ and $|\theta_{2,R'}|$ of the angles $\theta_1$ and $|\theta_2|$ and the corresponding length of $\rho_{1,R'}$ and $\rho_{2,R'}$. The above procedure can then be applied to calculate the new constant values $a'$ and $k'$ from (5) and (6) and the mirror shape from (4). The process can then be iterated to cover the desired numerical aperture with a proper number of nested mirrors.

Figure 6 shows the optical layout of a nested collector 300 according to a second embodiment of the invention. This is the same as the first embodiment, except as described hereinafter. The nested collector 300 consists of 15 double-reflection mirrors (302, 304, etc.) with a thickness of 2 mm. In this case, there is a focal length 2c of 1500 mm, a minimum distance $\bar{\rho}_1$ between the optics 300 and the source focus 306 of 110 mm and a minimum and maximum angles of the radiation at the intermediate focus 316 of 1.5° and 8°, respectively. The corresponding minimum and maximum collected angles are 9.2° and 86.8°, equivalent to 5.3 sr (taking into account the obscurations from the mirror thickness). As mentioned hereinbefore, the collection efficiency of the collector is defined as the ratio between the power at the image or intermediate focus and the power emitted from the source in $2\pi$ sr. For an isotropic point source, the collection efficiency of each mirror 302, 304, etc. is given by

$$\eta = \int_{\theta_{1,R}}^{\theta_{1,A}} R(\psi_{13})R(\psi_{23})\sin\theta_1 d\theta_1 = \int_{\theta_{1,R}}^{\theta_{1,A}} R^2\left(\frac{\theta_1 - \theta_2(\theta_1)}{4}\right)\sin\theta_1 d\theta_1. \tag{7}$$

where $R(\psi)$ is the mirror reflectivity at the grazing incidence angle $\psi$. Assuming a reflective coating of Ruthenium with theoretical reflectivity, the total collection efficiency for the collector in Fig. 6 is 50.9%. This value should be compared with the calculated efficiency of 40.1% for a reference collector design based on a type I Wolter configuration matching the same boundary conditions in terms of focal length, angles at the intermediate focus and maximum collected angle.

In accordance with embodiments of the invention, the manufacturing process for fabrication of each of the nested grazing incidence mirrors 302 (as well as the outer mirrors 304, etc.; see Fig. 6), of the assembly of nested mirrors as a whole, is based on electroforming, whereby the mirror 302, 304, etc. is obtained by galvanic replication from a negative master (not shown). In this case, it is appropriate to extend the two sections of the mirror providing the two reflecting surfaces 308, 312 until they join at a given point (R). In this way, the two sections of the mirror are manufactured in a monolithic structure, thus avoiding the need for further relative alignment. Techniques for the manufacture of mirrors by electroforming are disclosed in, for example, EP-A-1329040 and WO2005/054547.

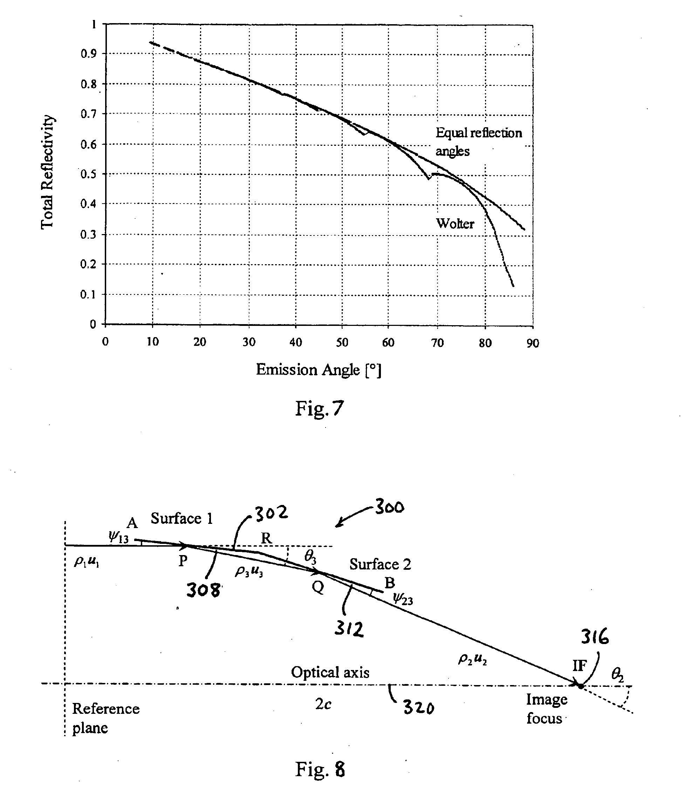

Figure 7 illustrates total reflectivity experienced by each ray as a function of the emission angle for the nested collector 300 of Fig. 6 and for a type I Wolter design. The nested collector 300 according to an embodiment of the invention is more effective than the type I Wolter design, at least at large emission angles. As the inner mirrors collect a small angular range, the gain in reflectivity at lower emission angles is more limited.

Figure 8 shows the geometry and conventions of the two-reflection mirror according to a third embodiment of the invention, when the source focus is at infinity, for example in EUV or X-ray imaging applications. The design is similar to the earlier embodiment, and so will be briefly discussed. In this case $u_1$ is parallel to the optical axis 320 and $\theta_1 = 0$, as shown in Fig. 8. Only the projection of equation (1) on the optical axis 320 is applicable,

$$\rho_1 + \rho_2 u_1 \cdot u_2 + \rho_3 u_1 \cdot u_3 = 2c. \tag{8}$$

Instead, equation (2) is still valid.

In accordance with embodiments of the invention, with the two grazing incidence angles $\Psi_{13} = -\theta_3/2$ and $\Psi_{23} = (\theta_3 - \theta_2)/2$ being equal, gives $\theta_3 = \theta_2/2$. Using the reflection conditions at point P and Q in Figure 8, with $\theta_2$ is chosen as the independent variable, in accordance with embodiments of the invention, the geometries of the reflective surfaces are defined by

$$\begin{cases} \rho_1 + \rho_3 \cos(\theta_2/2) = 2c - \rho_2 \cos(\theta_2) \\ \rho_1 + \rho_3 = 2a - \rho_2 \end{cases} \tag{9}$$

As before, with c assigned, the constants a and k are determined in accordance with embodiments of the invention, once the minimum value $|\theta_{2,R}|$ of the angle of $|\theta_2|$ at point R is given, by

$$a = \frac{\rho_{1,R} + \rho_{2,R}}{2}. \tag{10}$$

$$k = \rho_{2,R} \sin^4\left(\frac{\theta_{2,R}}{4}\right). \tag{11}$$

The process for the determination of the first 302 and subsequent (not shown) mirrors is then identical to that described for the collector 300 in the embodiment of Fig. 5.

In contrast with embodiments of the present invention, in double-reflection conical mirrors for X-ray telescopes, axial rays do not come to a point geometric focus and the optics is not corrected for on-axis spherical aberration.

The design of double-reflection mirrors 302, 304, etc. according to embodiments of the invention, with equal grazing incidence angles, is effective in increasing the efficiency of collectors for EUV microlithography, at least at large emission angles. The increasing demand for high power level needed for high volume manufacturing tools requires enhancing the performance of the subsystems to the physical limits. For collectors, this implies, among others, increasing the collected solid angle and improving the overall reflectivity. To this end, the collector optical systems according to the present invention have a collection efficiency 27% greater than a type I Wolter configuration for the selected reference specifications set out herein.

**Claims**

1.  A reflective optical system (300), in which radiation from a radiation source (306) is directed to an image focus (316), comprising:

    one or more mirrors (302), the or each mirror being symmetric about an optical axis (320) extending through the radiation source (306) and the or each mirror (302) having at least first (308) and second (312) reflective surfaces whereby, in use, radiation from the source undergoes successive grazing incidence reflections (P, Q) in an optical path at said first and second reflective surfaces (308, 312);
    **characterised in that** said at least first and second reflective surfaces (308, 312) are formed such that the angles of incidence of said successive grazing incidence reflections at said first and second reflective surfaces (308, 312) are substantially equal for all rays incident on said reflective surfaces.

2.  The system of claim 1, wherein, the or each mirror (302) is formed as an electroformed monolithic component, and wherein the first and second reflective surfaces (308, 312) are each provided on a respective one of two contiguous sections of the mirror (302).

3.  The system of claim 1 or 2, wherein, for the or each mirror:

    said at least first and second reflective surfaces (308, 312) have figures, and positions and/or orientations relative to the optical axis whereby said angles of incidence are equal.

4.  The system of any of claims 1 to 3, wherein, for the or each mirror (302):

    the first reflective surface (308) is nearest to the radiation source (306), and radiation from the second reflective surface (312) is directed to the image focus (316) on the optical axis (320); and
    wherein said first and second reflective surfaces (308, 312) are defined, for a given point of reflection at said reflective surfaces, by

$$\begin{cases} \rho_2\rho_1 = k\sin^{-4}\left(\dfrac{\theta_2 - \theta_1}{4}\right) \\[2mm] \rho_1 - \rho_2 = 2c\dfrac{\cos\theta_2 - \cos\theta_1}{\cos(\theta_1 - \theta_2) - 1} \\[2mm] \rho_1\cos\theta_1 + \rho_2\cos\theta_2 + (2a - \rho_1 - \rho_2)\cos\left(\dfrac{\theta_1 + \theta_2}{2}\right) = 2c \end{cases}$$

    where

        $\rho_1$ is the length from the source to the first reflective surface (308),
        $\rho_2$ is the length from the image focus (316) to the second reflective surface (312),

$\theta_1$ is the angle between the optical axis (320) and a line joining the source (306)and a first point of reflection (P) at the first reflective surface (308),

$\theta_2$ is the angle between the optical axis (320) and a line joining the image focus (316) and a second point of reflection (Q) at the second reflective surface (312),

2c is the length along the optical axis (320) from the source (306) to the image focus (316),

2a is the constant length of the optical path, and

k is a constant.

**5.** The system of claim 4, wherein:

$$a = \frac{\rho_{1,R} + \rho_{2,R}}{2},$$

and

$$k = \rho_{1,R} \rho_{2,R} \sin^4\left(\frac{\theta_{2,R} - \theta_{1,R}}{4}\right)$$

where subscript *R* denotes values for the point of intersection R of the first and second reflective surfaces (308, 312).

**6.** A collector optical system for EUV lithography, comprising the reflective optical system (300) of any of the preceding claims, wherein radiation is collected from the radiation source (306).

**7.** An EUV lithography system (100) comprising:

a radiation source, for example a LPP source (110),
the collector optical system (300) of claim 6;
an optical condenser (130); and
a reflective mask (140).

**8.** An imaging optical system for EUV or X-ray imaging, comprising the reflective optical system (300) of any of claims 1 to 5.

**9.** An EUV or X-ray imaging system, comprising:

the imaging optical system of claim 8; and
an imaging device, for example a CCD array, disposed at the image focus (316).

**10.** An EUV or X-ray telescope system, comprising:

the reflective optical system (300) of any of claims 1 to 3;
wherein radiation from a source at infinity is reflected to the image focus (316).

**11.** The system of claim 10, wherein, for the or each mirror (302):

the first reflective surface (308) is nearest to the radiation source, and radiation from the second reflective surface (312) is directed to the image focus (316); and
wherein said first and second reflective surfaces (308) are defined, for a given point of reflection at said reflective surfaces, by

$$\begin{cases} \rho_1 + \rho_3 \cos(\theta_2 / 2) = 2c - \rho_2 \cos(\theta_2) \\ \rho_1 + \rho_3 = 2a - \rho_2 \end{cases}$$

where

$\rho_1$ is the length from a reference plane to the first reflective surface (308),
$\rho_2$ is the length from the image focus (316) to the second reflective surface (312),
$\rho_3$ is the length between the points of incidence (P, Q) at said first (308) and second (312) reflective surfaces,
$\theta_2$ is the angle between the optical axis (320) and a line joining the image focus (316) and a second point of reflection (Q) at the second reflective surface (312),
2c is the length along the optical axis (320) from the source (306) to the image focus (316),
2a is the constant length of the optical path, and
k is a constant.

**12.** The system of claim 11, wherein:

$$a = \frac{\rho_{1,R} + \rho_{2,R}}{2},$$

and

$$k = \rho_{2,R} \sin^4\left(\frac{\theta_{2,R}}{4}\right),$$

where subscript *R* denotes values for the point of intersection R of the first and second reflective surfaces (308, 312).

**13.** An EUV or X-ray imaging system, comprising:

the EUV or X-ray telescope system of any of claims 10 to 12; and
an imaging device, for example a CCD array, disposed at the image focus (316).

**14.** The system of any of the preceding claims, wherein a plurality of mirrors (302, 304) are provided in nested configuration.

**15.** The system of claim 14, wherein two of more of the mirrors (302, 304) each have a different geometry.

**16.** The system of any of the preceding claims, wherein one or more of the mirrors (302, 304) has mounted thereon, for example on the rear side thereof, one or more devices for the thermal management of the mirror, for example cooling lines, Peltier cells and temperature sensors.

**17.** The system of any of the preceding claims, wherein one or more of the mirrors (302, 304) has mounted thereon, for example on the rear side thereof, one or more devices for the mitigation of debris from the source, for example erosion detectors, solenoids and RF sources.

**Patentansprüche**

**1.** Reflektierendes optisches System (300), bei dem Strahlung von einer Strahlungsquelle (306) auf einen Bildfokus (316) gerichtet wird und das Folgendes umfasst:

einen oder mehrere Spiegel (302), wobei der oder jeder Spiegel um eine optische Achse (320) symmetrisch ist, die durch die Strahlungsquelle (306) verläuft, und der oder jeder Spiegel (302) wenigstens eine erste (308) und eine zweite (312) reflektierende Fläche hat, so dass beim Gebrauch Strahlung von der Quelle aufeinander folgende streifende Einfallsreflexionen (P, Q) in einem Lichtweg an der genannten ersten und zweiten reflektierenden Fläche (308, 312) erfährt;
**dadurch gekennzeichnet, dass** die genannte wenigstens erste und zweite reflektierende Fläche (308, 312) so gebildet sind, dass die Einfallswinkel der genannten aufeinander folgenden streifenden Einfallsreflexionen an der genannten ersten und zweiten reflektierenden Fläche (308, 312) für alle auf die genannten reflektierenden Flächen fallenden Strahlen im Wesentlichen gleich sind.

2. System nach Anspruch 1, wobei der oder jeder Spiegel (302) als eine elektrogeformte monolithische Komponente ausgebildet ist und wobei die erste und zweite reflektierende Fläche (308, 312) jeweils auf einem jeweiligen von zwei nebeneinander liegenden Abschnitten des Spiegels (302) vorgesehen sind.

3. System nach Anspruch 1 oder 2, wobei für den oder jeden Spiegel:

   die genannte wenigstens erste und zweite reflektierende Fläche (308, 312) Figuren und Positionen und/oder Orientierungen relativ zu der optischen Achse haben, so dass die genannten Einfallswinkel gleich sind.

4. System nach einem der Ansprüche 1 bis 3, wobei für den oder jeden Spiegel (302):

   die erste reflektierende Fläche (308) der Strahlungsquelle (306) am nächsten liegt und Strahlung von der zweiten reflektierenden Fläche (312) auf den Bildfokus (316) auf der optischen Achse (320) gerichtet wird; und
   wobei die genannte erste und zweite reflektierende Fläche (308, 312) für einen gegebenen Reflexionspunkt an den genannten reflektierenden Flächen definiert werden durch:

$$\begin{cases} \rho_2\rho_1 = k\sin^{-4}\left(\dfrac{\theta_2 - \theta_1}{4}\right) \\[2mm] \rho_1 - \rho_2 = 2c\,\dfrac{\cos\theta_2 - \cos\theta_1}{\cos(\theta_1 - \theta_2) - 1} \\[2mm] \rho_1\cos\theta_1 + \rho_2\cos\theta_2 + (2a - \rho_1 - \rho_2)\cos\left(\dfrac{\theta_1 + \theta_2}{2}\right) = 2c \end{cases}$$

   wobei

   $\rho_1$ die Länge von der Quelle zur ersten reflektierenden Fläche (308) ist,
   $\rho_2$ die Länge vom Bildfokus (316) zur zweiten reflektierenden Fläche (312) ist,
   $\theta_1$ der Winkel zwischen der optischen Achse (320) und einer Linie ist, die die Quelle (306) und einen ersten Reflexionspunkt (P) an der ersten reflektierenden Fläche (308) verbindet,
   $\theta_2$ der Winkel zwischen der optischen Achse (320) und einer Linie ist, die den Bildfokus (316) und einen zweiten Reflexionspunkt (Q) an der zweiten reflektierenden Fläche (312) verbindet,
   2c die Länge entlang der optischen Achse (320) von der Quelle (306) zum Bildfokus (316) ist,
   2a die konstante Länge des Lichtwegs ist, und
   k eine Konstante ist.

5. System nach Anspruch 4, wobei:

$$a = \frac{\rho_{1,R} + \rho_{2,R}}{2} \qquad ,$$

   und

$$k = \rho_{1,R}\rho_{2,R}\sin^4\left(\frac{\theta_{2,R} - \theta_{1,R}}{4}\right) \quad ,$$

   wobei die Tiefstellung "R" Werte für den Schnittpunkt R der ersten und zweiten reflektierenden Fläche (308, 312) bedeutet.

6. Optisches Kollektorsystem für EUV-Lithografie, das das optische reflektierende System (300) nach einem der vorherigen Ansprüche umfasst, wobei Strahlung von der Strahlungsquelle (306) gesammelt wird.

7. EUV-Lithografiesystem (100), das Folgendes umfasst:

   eine Strahlungsquelle, z.B. eine LPP-Quelle (110),
   das optische Kollektorsystem (300) nach Anspruch 6;
   einen optischen Kondensor (130); und
   eine reflektierende Maske (140).

8. Optisches Abbildungssystem zur EUV- oder Röntgenabbildung, das das optische reflektierende System (300) nach einem der Ansprüche 1 bis 5 umfasst.

9. EUV- oder Röntgenabbildungssystem, das Folgendes umfasst:

   ein optisches Abbildungssystem nach Anspruch 8; und
   ein an dem Bildfokus (316) angeordnetes Abbildungsgerät, z.B. einen CCD-Array.

10. EUV- oder Röntgenteleskopsystem, das Folgendes umfasst:

    das reflektierende optische System (300) nach einem der Ansprüche 1 bis 3;
    wobei Strahlung von einer Quelle im Unendlichen auf den Bildfokus (316) reflektiert wird.

11. System nach Anspruch 10, wobei für den oder jeden Spiegel (302):

    die erste reflektierende Fläche (308) der Strahlungsquelle am nächsten liegt und Strahlung von der zweiten reflektierenden Fläche (312) auf den Bildfokus (316) gerichtet wird; und
    wobei die genannte erste und zweite reflektierende Fläche (308) für einen gegebenen Reflexionspunkt an der genannten reflektierenden Fläche definiert werden durch:

$$\begin{cases} \rho_1 + \rho_3 \cos(\theta_2/2) = 2c - \rho_2 \cos(\theta_2) \\ \rho_1 + \rho_3 = 2a - \rho_2 \end{cases}$$

    wobei $\rho_1$ die Länge von einer Referenzebene zur ersten reflektierenden Fläche (308) ist, $\rho_2$ die Länge vom Bildfokus (316) zur zweiten reflektierenden Fläche (312) ist,
    $\rho_3$ die Länge zwischen den Einfallspunkten (P, Q) an der genannten ersten (308) und zweiten (312) reflektierenden Fläche ist,
    $\theta_2$ der Winkel zwischen der optischen Achse (320) und einer Linie ist, die den Bildfokus (316) und einen zweiten Reflexionspunkt (Q) an der genannten zweiten reflektierenden Fläche (312) verbindet,
    2c die Länge entlang der optischen Achse (320) von der Quelle (306) zum Bildfokus (316) ist,
    2a die konstante Länge des Lichtwegs ist, und
    k eine Konstante ist.

12. System nach Anspruch 11, wobei:

$$a = \frac{\rho_{1,R} + \rho_{2,R}}{2} ,$$

    und

$$k = \rho_{2,R} \sin^4\left(\frac{\theta_{2,R}}{4}\right) ,$$

    wobei die Tiefstellung „R" Werte für den Schnittpunkt R der ersten und der zweiten reflektierenden Fläche (308, 312) bedeutet.

**13.** EUV- oder Röntgenabbildungssystem, das Folgendes umfasst:

das EUV- oder Röntgenteleskopsystem nach einem der Ansprüche 10 bis 12; und
ein am Bildfokus (316) angeordnetes Abbildungsgerät, z.B. einen CCD-Array.

**14.** System nach einem der vorherigen Ansprüche, wobei mehrere Spiegel (302, 304) in einer verschachtelten Konfiguration vorgesehen sind.

**15.** System nach Anspruch 14, wobei zwei oder mehrere der Spiegel (302, 304) jeweils eine andere Geometrie haben.

**16.** System nach einem der vorherigen Ansprüche, wobei eine oder mehrere Vorrichtungen (302, 304) für das thermische Management des Spiegels, z.B. Kühlleitungen, Peltier-Zellen und Temperatursensoren, an einem oder mehreren der Spiegel (302, 304), z.B. auf der Rückseite davon, montiert ist/sind.

**17.** System nach einem der vorherigen Ansprüche, wobei eine oder mehrere Vorrichtungen zum Verringern von Schmutz von der Quelle, z.B. Erosionsdetektoren, Solenoide und RF-Quellen, an einem oder mehreren der Spiegel (302, 304), z.B. auf der Rückseite davon, montiert ist/sind.

**Revendications**

**1.** Système optique réfléchissant (300), dans lequel le rayonnement venant d'une source de rayonnement (306) est dirigé vers un foyer-image (316), comprenant :

un ou plusieurs miroirs (302), le ou chaque miroir étant symétrique autour d'un axe optique (320) s'étendant à travers la source de rayonnement (306) et le ou chaque miroir (302) ayant au moins une première (308) et une deuxième (312) surface réfléchissante, ce qui fait que, en cours d'utilisation, le rayonnement venant de la source subit des réflexions successives à incidence rasante (P, Q) dans un chemin optique au niveau desdites première et deuxième surfaces réfléchissantes (308, 312) ;
**caractérisé en ce que** lesdites au moins première et deuxième surfaces réfléchissantes (308, 312) sont formées de manière à ce que les angles d'incidence desdites réflexions successives à incidence rasante au niveau desdites première et deuxième surfaces réfléchissantes (308, 312) sont essentiellement égaux pour tous les rayons incidents sur lesdites surfaces réfléchissantes.

**2.** Système selon la revendication 1, dans lequel le ou chaque miroir (302) est formé comme un composant monolithique électroformé, et dans lequel la première et la deuxième surface réfléchissante (308, 312) sont prévues chacune sur une section respective de deux sections contiguës du miroir (302).

**3.** Système selon la revendication 1 ou 2, dans lequel, pour le ou chaque miroir :

lesdites au moins première et deuxième surfaces réfléchissantes (308, 312) ont des formes, et des positions et/ou des orientations relatives à l'axe optique qui font que lesdits angles d'incidence sont égaux.

**4.** Système selon l'une quelconque des revendications 1 à 3, dans lequel, pour le ou chaque miroir (302) :

la première surface réfléchissante (308) est la plus proche de la source de rayonnement (306), et le rayonnement venant de la deuxième surface réfléchissante (312) est dirigé vers le foyer-image (316) sur l'axe optique (320) ; et dans lequel lesdites première et deuxième surfaces réfléchissantes (308, 312) sont définies, pour un point de réflexion donné au niveau desdites surfaces réfléchissantes, par

$$\begin{cases} \rho_2 \rho_1 = k \sin^{-4}\left(\dfrac{\theta_2 - \theta_1}{4}\right) \\[2mm] \rho_1 - \rho_2 = 2c \dfrac{\cos\theta_2 - \cos\theta_1}{\cos(\theta_1 - \theta_2) - 1} \\[2mm] \rho_1 \cos\theta_1 + \rho_2 \cos\theta_2 + (2a - \rho_1 - \rho_2)\cos\left(\dfrac{\theta_1 + \theta_2}{2}\right) = 2c \end{cases}$$

équation dans laquelle :

ρ$_1$ est la longueur entre la source et la première surface réfléchissante (308),
ρ$_2$ est la longueur entre le foyer-image (316) et la deuxième surface réfléchissante (312),
θ$_1$ est l'angle entre l'axe optique (320) et une ligne reliant la source (306) et un premier point de réflexion (P) au niveau de la première surface réfléchissante (308),
θ$_2$ est l'angle entre l'axe optique (320) et une ligne reliant le foyer-image (316) et un deuxième point de réflexion (Q) au niveau de la deuxième surface réfléchissante (312),
2c est la longueur le long de l'axe optique (320) entre la source (306) et le foyer-image (316),
2a est la longueur constante du chemin optique, et
*k* est une constante.

5.   Système selon la revendication 4, dans lequel :

$$a = \frac{\rho_{1,R} + \rho_{2,R}}{2}$$ ,

et

$$k = \rho_{1,R}\,\rho_{2,R}\,\sin^4\left(\frac{\theta_{2,R} - \theta_{1,R}}{4}\right)$$ ,

équation dans laquelle l'indice "R" indique des valeurs pour le point d'intersection R des première et deuxième surfaces réfléchissantes (308, 312).

6.   Système optique de collecte pour la lithographie par ultraviolets extrêmes, comprenant le système optique réfléchissant (300) selon l'une quelconque des revendications précédentes, dans lequel le rayonnement est recueilli depuis la source de rayonnement (306).

7.   Système de lithographie par ultraviolets extrêmes (100) comprenant :

une source de rayonnement, par exemple une source LPP (110),
le système optique de collecte (300) selon la revendication 6 ;
un condensateur optique (130) ; et
un masque réfléchissant (140).

8.   Système optique d'imagerie pour l'imagerie par ultraviolets extrêmes ou par rayons X, comprenant le système optique réfléchissant (300) selon l'une quelconque des revendications 1 à 5.

9.   Système d'imagerie par ultraviolets extrêmes ou par rayons X, comprenant :

le système optique d'imagerie selon la revendication 8 ; et
un dispositif d'imagerie, par exemple une mosaïque de DTC, disposé au foyer-image (316).

10.  Système télescopique à ultraviolets extrêmes ou à rayons X, comprenant :

le système optique réfléchissant (300) selon l'une quelconque des revendications 1 à 3 ;
dans lequel le rayonnement depuis une source à l'infini est réfléchi vers le foyer-image (316).

11.  Système selon la revendication 10, dans lequel, pour le ou chaque miroir (302) :

la première surface réfléchissante (308) est la plus proche de la source de rayonnement, et le rayonnement venant de la deuxième surface réfléchissante (312) est dirigé vers le foyer-image (316) ; et
dans lequel lesdites première et deuxième surfaces réfléchissantes (308) sont définies, pour un point de réflexion donné au niveau desdites surfaces réfléchissantes, par

$$\begin{cases} \rho_1 + \rho_3 \cos(\theta_2/2) = 2c - \rho_2 \cos(\theta_2) \\ \rho_1 + \rho_3 = 2a - \rho_2 \end{cases}$$

équation dans laquelle :

$\rho_1$ est la longueur entre un plan de référence et la première surface réfléchissante (308),
$\rho_2$ est la longueur entre le foyer-image (316) et la deuxième surface réfléchissante (312),
$\rho_3$ est la longueur entre les points d'incidence (P, Q) au niveau desdites première (308) et deuxième (312) surfaces réfléchissantes,
$\theta_2$ est l'angle entre l'axe optique (320) et une ligne reliant le foyer-image (316) et un deuxième point de réflexion (Q) au niveau de la deuxième surface réfléchissante (312),
2c est la longueur le long de l'axe optique (320) entre la source (306) et le foyer-image (316),
2a est la longueur constante du chemin optique, et
k est une constante.

**12.** Système selon la revendication 11, dans lequel :

$$a = \frac{\rho_{1,R} + \rho_{2,R}}{2},$$

et

$$k = \rho_{2,R} \sin^4\left(\frac{\theta_{2,R}}{4}\right),$$

équation dans laquelle l'indice "R" indique des valeurs pour le point d'intersection R des première et deuxième surfaces réfléchissantes (308, 312).

**13.** Système d'imagerie par ultraviolets extrêmes ou par rayons X, comprenant :

le système télescopique à ultraviolets extrêmes ou à rayons X selon l'une quelconque des revendications 10 à 12 ; et
un dispositif d'imagerie, par exemple une mosaïque de DTC, disposé au foyer-image (316).

**14.** Système selon l'une quelconque des revendications précédentes, dans lequel une pluralité de miroirs (302, 304) sont prévus dans une configuration imbriquée.

**15.** Système selon la revendication 14, dans lequel deux ou plus des miroirs (302, 304) ont chacun une géométrie différente.

**16.** Système selon l'une quelconque des revendications précédentes, dans lequel, sur un ou plus des miroirs (302, 304) sont montés, par exemple sur le côté arrière de ceux-ci, un ou plusieurs dispositifs pour la gestion thermique du miroir, par exemple des conduites de refroidissement, des cellules Peltier et des capteurs de température.

**17.** Système selon l'une quelconque des revendications précédentes, dans lequel, sur un ou plus des miroirs (302, 304) sont montés, par exemple sur le côté arrière de ceux-ci, un ou plusieurs dispositifs pour la réduction des débris provenant de la source, par exemple des détecteurs d'érosion, des solénoïdes et des sources RF.

FIG. 1 (PRIOR ART)

210
215
205
Energetic ions or particles
EUV light
Discharge source
Supporting structure
210
Grazing incident
collector optic

FIG. 2 (PRIOR ART)

Fig. 3 (PRIOR ART)

Fig. 4

Fig. 5

Fig. 6

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040265712 A1
- US 20050016679 A1
- US 20050155624 A1
- US 20060097202 A
- US 200401084731 A
- EP 1329040 A
- WO 2005054547 A


**Non-patent literature cited in the description**

- **Zocchi, Fabio et al.** Design and optimisation of collectors for extreme ultraviolet lithography. *Proc. SPIE,* vol. 6151, 615110T-1615110T-11